# DEMANDE DE BREVET EUROPEEN

(11) **EP 2 541 634 A1**
(43) Date de publication de la demande: **02.01.2013**
(21) Numéro de dépôt: 12173478.4
(22) Date de dépôt: 25.06.2012
(51) Int. Cl.: H01L 35/26, H01L 35/32

(54) **Elément, module et dispositif thermo électrique, notamment destinés à générer un courant électrique dans un véhicule automobile**

(30) Priorité: 30.06.2011 FR 1155879
(71) Demandeur: Valeo Systèmes Thermiques, 78321 Le Mesnil Saint Denis Cedex (FR); Simonin, Michel, 78960 Voisins le Bretonneux (FR)
(72) Inventeur: Simonin, Michel, 78960 VOISINS LE BRETONNEUX (FR)
(74) Mandataire: Rolland, Jean-Christophe

(57) **Abrégé**

L'invention concerne un élément thermo électrique (3) permettant la génération d'un courant électrique à partir d'un gradient de température appliqué entre deux de ses faces (4a, ab), ledit élément (3) comprenant un matériau de base, apportant audit élément ses caractéristiques thermo électrique, et un matériau de dopage, apte à modifier les caractéristiques apportées audit élément par le matériau de base.

Selon l'invention, ledit élément présente un taux de dopage croissant entre lesdites deux faces (4a, 4b), le taux de dopage étant défini comme la proportion de matériau de dopage par unité de volume.

## Description

La présente invention concerne élément, un module et un dispositif thermo électriques, notamment destinés à générer un courant électrique dans un véhicule automobile.

Dans le domaine automobile, il a déjà été proposé des dispositifs thermo électriques utilisant des éléments, dits thermo électriques, permettant de générer un courant électrique en présence d'un gradient de température entre deux de leurs faces opposées selon le phénomène connu sous le nom d'effet Seebeck. Ces dispositifs comprennent un empilement de premiers tubes, destinés à la circulation des gaz d'échappement d'un moteur, et de seconds tubes, destinés à la circulation d'un fluide caloporteur d'un circuit de refroidissement. Les éléments thermo électriques sont pris en sandwich entre les tubes de façon à être soumis à un gradient de température provenant de la différence de température entre les gaz d'échappement, chauds, et le fluide de refroidissement, froid.

De tels dispositifs sont particulièrement intéressants car ils permettent de produire de l'électricité à partir d'une conversion de la chaleur provenant des gaz d'échappement du moteur. Ils offrent ainsi la possibilité de réduire la consommation en carburant du véhicule en venant se substituer, au moins partiellement, à l'alternateur habituellement prévu dans celui-ci pour générer de l'électricité à partir d'une courroie entrainée par le vilebrequin du moteur.

Les éléments thermo électriques connus comprennent un matériau de base leur donnant leur propriété thermo électrique. Ce matériau se présente sous la forme d'une structure cristalline présentant des trous dans lesquels un matériau de dopage est inséré. Ce matériau de dopage intervient sur une ou plusieurs caractéristiques physiques des éléments thermo électriques pour améliorer leur performance par l'intermédiaire, notamment, d'une réduction de leur résistance électrique, une augmentation de leur pouvoir thermo isolant ou autres. Ce matériau est cependant constitué de composants très couteux.

L'invention a notamment pour but de limiter leur usage tout en conservant, voire en améliorant les performances des éléments thermo électriques.

Elle propose à cet effet un élément thermo électrique permettant la génération d'un courant électrique à partir d'un gradient de température appliqué entre deux de ses faces, ledit élément comprenant un matériau de base, apportant audit élément ses caractéristiques thermo électrique, et un matériau de dopage, apte à modifier les caractéristiques apportées audit élément par le matériau de base. Selon l'invention, ledit élément présente un taux de dopage croissant entre lesdites deux faces, le taux de dopage étant défini comme la proportion de matériau de dopage par unité de volume.

En répartissant ainsi le matériau de dopage, plutôt qu'en utilisant le taux de dopage uniforme rencontré dans les éléments thermo électrique de l'état de l'art, on utilise le matériau de dopage à l'endroit où il est le plus efficace en regard de l'effet recherché. On peut de la sorte diminuer la quantité de matériau de dopage employé tout en maintenant voire en augmentant les performances de l'élément thermo électrique.

Selon différents modes de réalisation, qui pourront être pris ensemble ou séparément :
- ledit matériau de dopage est constitué de terres rares, notamment de germanium,
- l'élément comprend une pluralité de couches superposées entre lesdites deux faces, le taux de dopage étant constant dans chacune desdites couches et variant d'une couche à l'autre,
- lesdites deux faces sont prévues de surface différente et ledit élément présente un taux de dopage croissant de celle desdites deux faces présentant la surface la plus grande à celle desdites deux faces présentant la surface la plus faible,
- l'élément est prévu de forme annulaire et les couches sont disposées concentriquement, la couche interne présentant le taux dopage le plus élevé.

L'invention concerne aussi un procédé de fabrication d'éléments thermo électrique dans lequel :
- on prévoit différents mélanges dudit matériau thermo électrique et dudit matériau de dopage, présentant un taux de dopage donné,
- on dispose les mélanges de matériaux en couches situées les unes contre les autres,
- on effectue un traitement thermique desdites couches de mélange de matériau.

Selon un exemple de réalisation du procédé de l'invention :
- on dispose au moins un séparateur, notamment un feuillard, cylindrique dans une cavité de moulage cylindrique de façon coaxiale à ladite cavité de moulage,
- on verse lesdits mélanges de matériau thermo électrique et de matériau de dopage présentant un taux de dopage donné de part et d'autre du ou des séparateurs afin de créer les différentes couches,
- on retire ensuite le ou les séparateurs avant d'effectuer le traitement thermique.

Les couches présentant des taux de dopages différents sont ainsi disposées concentriquement, ce qui permet de fabriquer les éléments thermo électriques de forme annulaire décrits précédemment.

Selon un aspect de l'invention :
- on dispose un matériau thermo électrique en formant des parois destinées à définir lesdites faces de l'élément thermo électrique,
- on effectue le traitement thermique entre lesdites parois destinées à définir lesdites faces de l'élément thermo électrique.

On pourra d'ailleurs noter que cet aspect de l'invention trouve un intérêt avec des éléments thermo électriques ne présentant pas nécessairement un taux de dopage évolutif.

Ainsi, l'invention concerne aussi un procédé de fabrication d'éléments thermo électriques en forme d'anneau permettant la génération d'un courant électrique à partir d'un gradient de température appliqué entre deux de ses faces, dites première et seconde faces, procédé dans lequel :
- on dispose un matériau thermo électrique selon une forme annulaire en formant des parois destinées à définir les première et seconde faces de l'élément thermo électrique, une première desdites parois étant une paroi interne de la forme annulaire et une seconde desdites parois étant une paroi externe de la forme annulaire.
- on effectue un traitement thermique entre lesdites première et seconde parois.

Le traitement thermique comprend, par exemple, une étape dans laquelle on fait circuler un courant électrique à travers le matériau thermo électrique entre lesdites première et seconde parois.

On pourra employer pour cela un dispositif à décharges électriques comprenant une première et une deuxième électrode disposées, notamment, de façon coaxiale, le matériau thermo électrique étant disposé en couronne entre la première et la deuxième électrodes.

Ce procédé présente notamment l'avantage de pouvoir traiter en une seule opération un matériau thermo électrique présentant une grande longueur ou un empilement de matériau thermo électrique présentant une grande longueur dans le but de fabriquer en une seule étape un élément thermo électrique de grande longueur ou de nombreux éléments thermo électrique, la distance faible entre les deux électrodes situées à l'intérieur et à l'extérieur de l'empilement annulaire ne dépendant pas de la longueur de l'empilement.

L'invention concerne aussi un module thermo électrique comprenant au moins un élément thermo électrique tel que décrit plus haut.

Selon un aspect de l'invention, ledit module est configuré pour établir, d'une part, un échange thermique entre celle des deux faces la plus grande, dite première face, dudit élément thermo électrique et un premier fluide et, d'autre part, pour établir un échange thermique entre celle des deux faces la plus petite, dite seconde face, dudit élément thermo électrique et un second fluide, ledit second fluide présentant un coefficient d'échange thermique supérieure audit premier fluide.

En utilisant une surface d'échange plus grande au niveau du fluide présentant le coefficient d'échange le plus faible, il est ainsi possible de disposer d'un rapport entre la résistance thermique côté premier fluide et la résistance thermique côté second fluide plus équilibré, favorisant le fonctionnement de l'ensemble.

Selon différents modes de mise en oeuvre de cet aspect de l'invention, qui pourront être pris ensemble ou séparément :
- la première surface est définie par une surface de périphérie extérieure de l'anneau définissant l'élément thermo électrique et la seconde surface est définie par une surface de périphérie intérieure dudit anneau,
- lesdites première et/ou seconde surfaces sont générées par une droite,
- lesdites première et/ou seconde surfaces sont de forme cylindrique,
- la première surface présente un rayon compris entre 1,5 et 4 fois le rayon de la seconde surface,
- lesdites première et/ou seconde surfaces sont coaxiales,
- ledit élément thermo électrique présente deux faces planes parallèles opposées,
- le module comprend une pluralité de dits éléments thermo électriques,
- lesdits éléments thermo électriques sont de deux types, un premier type, dit P, permettant d'établir une différence de potentiel électrique entre lesdites première et deuxième faces, lorsqu'ils sont soumis à un gradient de température donné, et d'un second type, dit N, permettant la création d'une différence de potentiel électrique dans un sens opposé entre lesdites première et deuxième faces, lorsqu'ils sont soumis au même gradient de température,
- lesdits éléments thermo électriques sont disposés dans le prolongement longitudinal l'un de l'autre et les éléments thermo électriques de type P alternent avec les éléments thermo électriques de type N,
- les éléments thermo électriques sont groupés par paires, formées d'un dit élément thermo électrique de type P et d'un dit élément thermo électrique de type N, ledit module étant configuré pour permettre une circulation de courant entre les premières surfaces des éléments thermo électriques d'une même paire et une circulation de courant entre les secondes surfaces de chacun des éléments thermo électriques de ladite même paire et l'élément thermo électrique voisin de la paire voisine,
- lesdits éléments thermo électriques sont disposés les uns par rapport aux autres de façon à ce que leur première et/ou seconde surface soient dans le prolongement l'une de l'autre,
- lesdits éléments thermo électriques sont de forme et de dimension identiques,
- lesdites première et/ou seconde surfaces des modules sont inscrites dans une surface générée par une droite,
- le module comprend un canal de circulation du second fluide au contact de ladite seconde surface desdits éléments thermo électriques et/ou un canal de circulation du premier fluide au contact de ladite première surface desdits éléments thermo électriques,
- le ou lesdits canaux de circulation du second fluide sont circulaire et le canal de circulation du premier fluide est annulaire, lesdits éléments thermo électriques étant disposés radialement entre le ou lesdits canaux de circulation du premier fluide, d'une part, et le canal de circulation du second fluide, d'autre part.
- le canal de circulation du premier fluide est muni de surfaces d'échange secondaire,
- le module comprend une enveloppe externe isolante, notamment une enveloppe permettant une isolation thermique entre des gaz d'échappement et l'air ambiant,
- ladite enveloppe externe définit une paroi externe du canal de circulation du premier fluide.

L'invention concerne encore un dispositif thermo électrique, notamment destiné à générer un courant électrique dans un véhicule automobile, comprenant au moins un module tel que décrit plus haut.

Selon différents modes de mise en oeuvre de cet aspect de l'invention, qui pourront être pris ensemble ou séparément :
- ledit dispositif comprend un corps présentant une pluralité de logements accueillant lesdits modules,
- ledit corps est en matériau réfractaire, isolant et/ou alvéolaire,
- lesdits modules sont maintenus dans lesdits logements par les surfaces d'échange secondaires,
- lesdits logements sont disposés de façon à ce que les canaux de circulation du gaz des différents modules soient parallèles les uns aux autres,
- le dispositif comprend un canal de circulation de gaz by-passant lesdits modules,
- ledit corps est revêtu d'une enveloppe externe anti-choc.

L'invention sera mieux comprise à la lumière de la description suivante qui n'est donnée qu'à titre indicatif et qui n'a pas pour but de la limiter, accompagnée des dessins joints parmi lesquels :
- la figure 1 illustre de façon schématique, selon un plan de coupe axiale, un premier exemple de module conforme à l'invention,
- la figure 2 est une vue de coupe selon la ligne II-II de la figure 1, illustrant une portion dudit premier exemple de module conforme à l'invention,
- les figures 3a à 3e illustre de façon schématique, en perspective, les différentes étapes de montage d'un deuxième exemple de module conforme à l'invention,
- la figure 4 illustre en vue de coupe axiale, un exemple de réalisation d'un élément thermo électrique pouvant être employé dans les modules des figures précédentes,
- la figure 5 illustre de façon schématique en perspective le corps d'un exemple de dispositif conforme à l'invention,
- la figure 6 illustre un exemple de dispositif conforme à l'invention muni du corps de la figure 5.

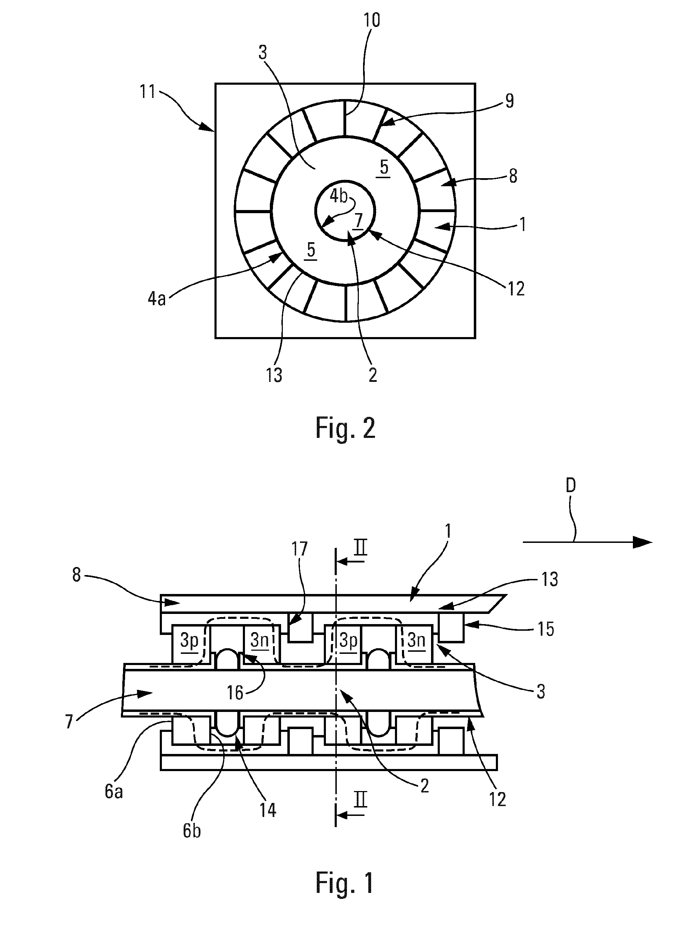

Comme illustré aux figures 1 à 3, l'invention concerne un module thermo électrique, comprenant ici un premier circuit 1, dit chaud, apte à permettre la circulation d'un premier fluide, notamment des gaz d'échappement d'un moteur, et un second circuit 2, dit froid, apte à permettre la circulation d'un second fluide, notamment un fluide caloporteur d'un circuit de refroidissement, de température inférieure à celle du premier fluide.

Le module comprend également une pluralité d'élément thermo électrique 3, 3p, 3n, susceptibles de générer un courant électrique sous l'action d'un gradient de température exercé entre deux de leurs faces 4a, 4b. De tels éléments fonctionnent, selon l'effet Seebeck, en permettant de créer un courant électrique dans une charge connectée entre lesdites faces 4a, 4b soumises au gradient de température. De façon connue de l'homme du métier, de tels éléments sont constitués, par exemple, de Bismuth et de Tellurium (Bi₂Te₃).

Les éléments thermo électriques sont, pour une première partie, des éléments 3p d'un premier type, dit P, permettant d'établir une différence de potentiel électrique dans un sens, dit positif, lorsqu'ils sont soumis à un gradient de température donné, et, pour l'autre partie, des éléments 3n d'un second type, dit N, permettant la création d'une différence de potentiel électrique dans un sens opposé, dit négatif, lorsqu'ils sont soumis au même gradient de température.

L'une 4a, dite première, desdites faces est de surface supérieure à l'autre 4b, dite seconde, et ledit module est configuré pour établir un échange thermique entre ladite première face et le premier fluide et pour établir un échange thermique entre ladite seconde face et le second fluide, ledit second fluide présentant un coefficient d'échange thermique supérieure audit premier fluide.

On favorise ainsi l'échange entre les éléments thermo électriques 3p, 3n, et le fluide présentant le coefficient d'échange thermique le plus faible, ici, les gaz d'échappement.

On décrit dans la suite un exemple de forme des éléments thermo électriques équipant le module conforme à l'invention.

Ses dites première 4a et/ou seconde 4b surfaces sont, par exemple, générées par une droite. Cela facilitera la configuration des circuits de fluide 1, 2. Elles sont ainsi, notamment, de forme cylindrique.

On pourra de la sorte utiliser un élément thermo électrique en forme d'anneau ou de portion d'anneau, la première surface 4a étant définie par une surface de périphérie extérieure de l'anneau tandis que la seconde surface 4b est définie par une surface de périphérie intérieure de l'anneau.

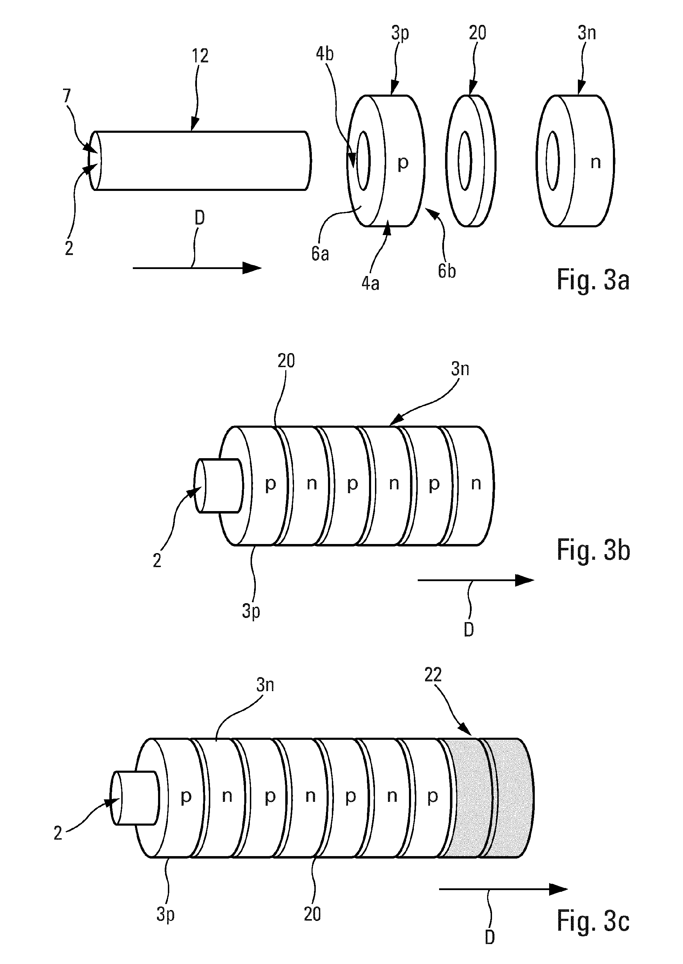

A la figure 2, l'élément thermo électrique 3 représenté est constitué d'un anneau formé de deux demi-anneaux 5 identiques et disposés symétriquement l'un par rapport à l'autre. Aux figures 3a à 3f, il s'agit d'anneaux en seule pièce.

La première surface 4a présente, par exemple, un rayon compris entre 1,5 et 4 fois le rayon de la seconde surface 4b. Il pourra s'agir d'un rayon égal à environ 2 fois celui de la seconde surface 4b.

Pour faciliter l'homogénéité de l'échange thermique angulairement le long de l'éléments thermo électrique, lesdites première et/ou seconde surfaces 4a, 4b sont, par exemple coaxiales. Autrement dit, l'élément thermo électrique est muni d'une épaisseur radiale constante.

Ledit élément thermo électrique présente, par exemple, deux faces planes 6a, 6b parallèles opposées. Autrement dit, l'anneau constituant l'élément thermo électrique est de section annulaire rectangulaire.

On décrit dans la suite un exemple d'association des éléments thermo électriques entre eux dans le module conforme à l'invention.

Lesdits éléments thermo électriques 3p, 3n sont disposés dans le prolongement longitudinal l'un de l'autre, notamment de façon coaxiale, et les éléments thermo électriques de type P alternent avec les éléments thermo électriques de type N, selon une direction D. Ils sont, notamment, de forme et de dimension identiques.

Lesdits éléments thermo électriques 3p, 3n sont, par exemple, groupés par paire, chaque paire étant formée d'un dit élément thermo électrique de type P et d'un dit élément thermo électrique de type N, et ledit module est configuré pour permettre une circulation de courant entre les premières surfaces des éléments thermo électriques d'une même paire et une circulation de courant entre les secondes surfaces de chacun des éléments thermo électriques de ladite même paire et l'élément thermo électrique voisin de la paire voisine. Ceci est particulièrement illustré dans le mode de réalisation de la figure 1 où la circulation du courant électrique est symbolisée par des traits en pointillés. On assure de la sorte une circulation en série du courant électrique entre les éléments thermo électriques 3p, 3n disposés les uns à côtés des autres selon la direction D.

A nouveau pour faciliter la configuration des circuits de circulation de fluide 1, 2, on pourra prévoir que lesdits éléments thermo électriques 3p, 3n soient disposés les uns par rapport aux autres de façon à ce que leur première et/ou seconde surface 4a, 4b soient dans le prolongement l'une de l'autre. Lesdites première et/ou seconde surfaces 4a, 4b sont ainsi inscrites, par exemple, dans une surface générée par une droite.

Pour la circulation des fluides, le module conforme à l'invention pourra comprendre un canal 7 de circulation du second fluide au contact de ladite seconde surface 4b desdits éléments thermo électriques 3p, 3n et/ou un canal 8 de circulation du premier fluide au contact de ladite première surface 4a desdits éléments thermo électriques 3p, 3n.

Le ou lesdits canaux 7 de circulation du second fluide sont, par exemple, de section circulaire. Ledit canal 8 de circulation du premier fluide est, par exemple de section annulaire. Lesdits éléments thermo électriques 3p, 3n sont, disposés entre lesdits canaux 7, 8, par exemple, radialement.

Selon les modes de réalisation des figures 1 et 2, d'une part, et 3a à 3e, d'autre part, ledit canal 7 de circulation du second fluide et ledit canal 8 de circulation du premier fluide sont coaxiaux.

Pour améliorer encore l'échange thermique entre les éléments thermo électriques 3p, 3n et le second fluide, le canal 8 de circulation de gaz pourra être muni de surfaces d'échange secondaire 9. Il s'agit, par exemple, d'ailettes radiales 10. Comme détaillé plus loin, lesdites surfaces d'échange secondaire pourront également avoir d'autres fonction, notamment de montage.

Afin de le protéger et de l'isoler de l'extérieur, le module conforme à l'invention pourra comprendre une enveloppe externe isolante 11, définissant éventuellement une paroi externe du canal 8 de circulation du premier fluide.

Selon le mode de réalisation des figures 1 et 2, le module conforme à l'invention comprend une pluralité de tubes 12, positionnés dans le prolongement axial les uns des autres de manière à définir ledit canal 7 de circulation de fluide froid. Il comprend également une pluralité de tubes 13, positionnés dans le prolongement axial les uns des autres de manière à définir des portions successives d'une paroi intérieure dudit canal 8 de circulation de gaz.

Les tubes 13 de circulation de gaz sont, par exemple, coaxiaux par rapport aux tubes 12 de circulation de liquide froid qui sont placés à l'intérieur desdits tubes 13 de circulation de gaz en étant axialement décalés par rapport à ceux-ci. Plus précisément, un tube 12 de circulation de liquide froid est ici centré, selon la direction D, entre deux tubes 13 de circulation de gaz.

A chaque tube 12 du canal 7 de circulation de liquide froid, il est associé une paire d'éléments thermo électriques 3p, 3n. Aux tubes 13 de circulation de gaz voisins, c'est-à-dire, aux tubes 13 à l'intérieur desquels ledit tube 12 de circulation de liquide froid est placé, l'un desdits éléments thermo électriques 3p, 3n dudit tube 12 est associé ainsi qu'un élément 3n, respectivement 3p de la paire d'éléments thermo électriques 3p, 3n voisine.

Des joints d'étanchéité 14, 15 pourront aussi être prévus entre lesdits tubes 12 de circulation du liquide froid successifs et/ou entre lesdits tubes 13 de circulation de gaz successifs. Outre leur rôle d'étanchéité, ils assurent une isolation électrique, respectivement, entre lesdits tubes 12 de circulation du liquide froid et/ou entre lesdits tubes 13 de circulation de gaz.

Lesdits tubes 12, 13 sont, par exemple, métalliques. Ils sont revêtus, par exemple, d'une fine couche de matériau, par exemple céramique, assurant une conduction thermique et une isolation électrique entre les tubes et les éléments thermo électriques. Pour la conduction électrique entre les éléments thermo électriques 3p, 3n, ladite couche de matériau pourra être revêtue de pistes électriques.

Dans ce mode de réalisation, les ailettes 10 sont, par exemple, issues de matière des tubes 13 de circulation de gaz qui sont obtenus, par exemple, par extrusion.

Dans ce module, les tubes 12, 13 de circulation de liquide froid et/ou de circulation de gaz pourront être munis d'épaulements 16, 17 contre lesquels les éléments thermo électriques 3p, 3n et/ou les joints d'étanchéité 14, 15 sont en appui. Lesdits épaulements sont prévus, par exemple, à l'extrémité longitudinale desdites tubes 12, 13.

Les éléments thermo électriques 3p, 3n sont en appui, sur l'une de leur face plane 6a, contre les épaulements 17 des tubes 13 de circulation de gaz au niveau de leur périphérie externe et, sur leur face plane opposée 6b, contre les épaulements 16 de tube de circulation de liquide froid au niveau de leur périphérie interne. Les joint 14, 15 sont placés entre deux épaulements de tubes 12, 13 respectifs.

A titre d'exemple, le montage du module est réalisé par expansion radiale des tubes 12 de circulation du liquide froid de manière à plaquer lesdits éléments thermo électriques 3p, 3n sur les tubes 13 de circulation de gaz. En variante, il est obtenu par serrage des tubes de circulation de gaz 13 de manière à plaquer les éléments thermo électriques 3p, 3n sur les tubes 12 de circulation de liquide froid. Un matériau assurant un meilleur contact entre les éléments thermo électriques 3p, 3n et les tubes pourra aussi être employé.

Selon le mode de réalisation des figures 3a à 3e, le module conforme à l'invention comprend un tube 12 de circulation de liquide froid sur lequel sont montés au moins deux éléments thermo électriques du même type alternant selon la direction d'extension longitudinale D du tube avec un éléments thermo électriques de l'autre type. En l'occurrence, comme cela ressort des figures 3b à 3e, une pluralité d'éléments thermo électriques 3p alterne avec une pluralité d'éléments thermo électriques 3n.

Si l'on se rapporte à la figure 3a, on constate qu'une rondelle 20, électriquement isolante, pourra être disposée entre deux faces 6a, 6b en vis-à-vis d'éléments thermo électriques voisins 3p, 3n selon la direction d'extension D longitudinale du tube 12. A la figure 3b, les éléments thermo électriques 3p, 3n, et les rondelles 20 sont assemblés, de façon alternée, sur le tube 12 de circulation de fluide froid.

Comme illustré à la figure 3c, les éléments thermo électriques 3p, 3n sont, par exemple, revêtus deux à deux d'une couche 22 de matière électriquement conductrice, notamment en cuivre et/ou en nickel.

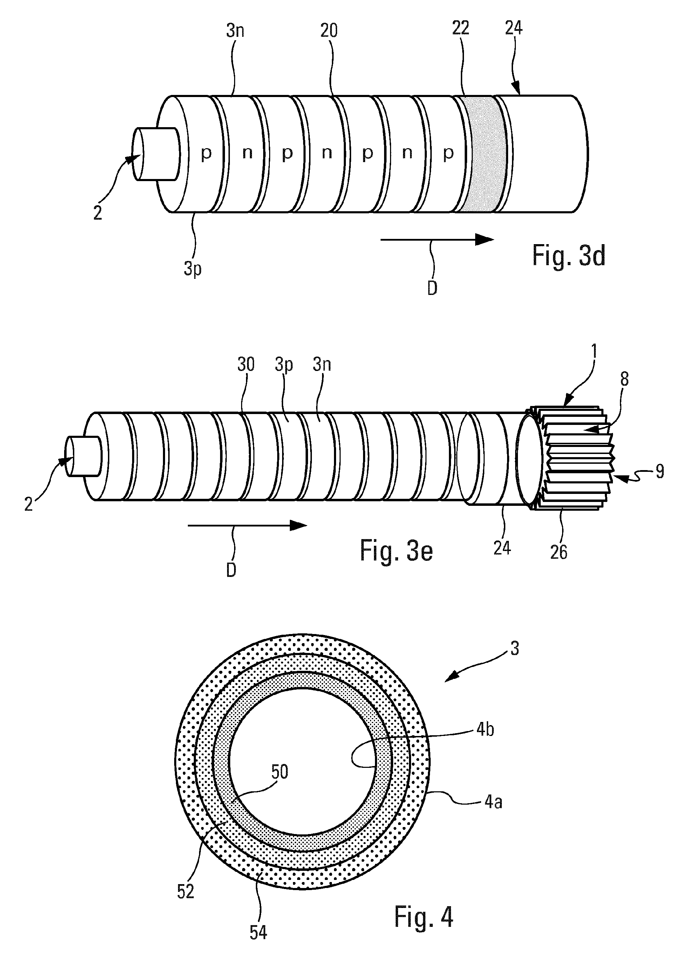

Comme illustré à la figure 3d, les éléments thermo électriques 3p, 3n sont aussi revêtus, par exemple, d'une couche 24 de matériau, isolante électriquement et conductrice thermiquement, définissant au moins en partie une paroi intérieure du canal 8 de circulation de gaz. Il s'agit, notamment, d'un matériau céramique. Ladite couche 24 de matière isolante électriquement et conductrice thermiquement est située au dessus de la couche 22 de matière électriquement conductrice

Le tube froid 12 est, notamment, métallique. Comme dans le précédent mode de réalisation, il est revêtu, par exemple, d'une fine couche de matériau, par exemple céramique, assurant une conduction thermique et une isolation électrique entre le tube et les éléments thermo électriques 3p, 3n. Pour la conduction électrique entre les éléments thermo électriques 3p, 3n, ladite couche de matériau pourra être revêtue de pistes électriques, notamment dans le but d'assurer une connexion en série des éléments thermo électriques le long de la direction D.

Comme illustré à la figure 3e, la surface d'échange secondaire 9 de ce type de module est configurée pour assurer le maintien des éléments thermo électriques 3p, 3n. Il s'agit, par exemple, d'un turbulateur 26, métallique, présentant une élasticité radiale et propre à subir une précompression.

Bien que cela ne soit pas représenté en relation avec le mode de réalisation des figures 3a à 3e, la périphérie extérieure du canal 8 de circulation de gaz est entourée d'une enveloppe de matériau protectrice, réfractaire et/ou isolante. Ladite enveloppe pourra former une surface d'appui pour le turbulateur 26.

Comme illustré à la figure 4, l'invention concerne aussi un élément thermo électrique qui pourra trouver ses applications, notamment, dans les modules décrits plus haut.

Ledit élément thermo électrique 3 comprend un matériau de base, apportant audit élément ses caractéristiques thermo électrique, et un matériau de dopage, apte à modifier les caractéristiques apportées audit élément par le matériau de base.

Ledit élément thermo électrique 3 présente un taux de dopage croissant entre lesdites deux faces 4a, 4b, le taux de dopage étant défini comme la proportion de matériau de dopage par unité de volume.

On optimise de la sorte la distribution de dopants que l'on peut adapter à l'effet que l'on souhaite mettre en avant, ceci à quantité de matériau de dopage constant, voire réduit par rapport à l'état de l'art.

Le matériau de base constitue la majorité voir l'essentiel de la composition de l'élément thermo électrique 3. A titre d'exemple, la proportion de matériau de dopage sera de l'ordre du pourcent. Elle pourra cependant monter dans certains cas jusqu'à 30 ou 40%.

Ledit matériau de dopage est constitué, par exemple, de terres rares, notamment de germanium.

Ledit élément thermo électrique 3 comprend, par exemple, une pluralité de couches 50, 52, 54 superposées entre lesdites deux faces 4a, 4b dudit élément thermo électrique, le taux de dopage étant constant dans chacune desdites couches et variant d'une couche à l'autre. Le taux de dopage pourra d'ailleurs être alors défini comme la proportion de matériau de dopage présent dans chacune des couches 50, 52, 54 sur la quantité totale de matière de la couche.

Lesdites deux faces 4a, 4b pourront être prévues de surface différente et ledit élément présente un taux de dopage croissant de celle 4a desdites deux faces présentant la surface la plus grande à celle 4b desdites deux faces présentant la surface la plus faible.

La concentration en dopant varie de la sorte selon le rayon de l'élément thermo électriques 3. En l'occurrence, il permet d'adapter la résistance électrique desdites surfaces 4a, 4b pour tenir compte de leur différence de taille en donnant à la surface 4b la plus faible une résistance électrique par unité de surface plus faible qu'à la surface 4a la plus grande.

A titre d'exemple, ledit élément thermo électrique comprend trois couches 50, 52, 54 de matériau thermo électrique présentant chacune un taux de dopage spécifique.

Ledit élément thermo électrique est ici prévu de forme annulaire et les couches 50, 52, 54 sont disposées concentriquement, la couche interne 50 présentant le taux dopage le plus élevé.

Une telle forme convient particulièrement pour les modules tels que ceux des figures 1 à 3, sans toutefois être limités à telle utilisations. Lesdits éléments thermo électrique pourront cependant présenter d'autres formes telles que, comme déjà évoqué, des formes en portion angulaire d'anneau, ou encore des formes leur permettant d'être utilisés dans des modules différents des exemples particuliers de modules illustrés.

L'invention concerne encore un dispositif comprenant une pluralité de modules tels que décrit plus haut, en particulier des modules tels que celui illustré aux figures 3a à 3e.

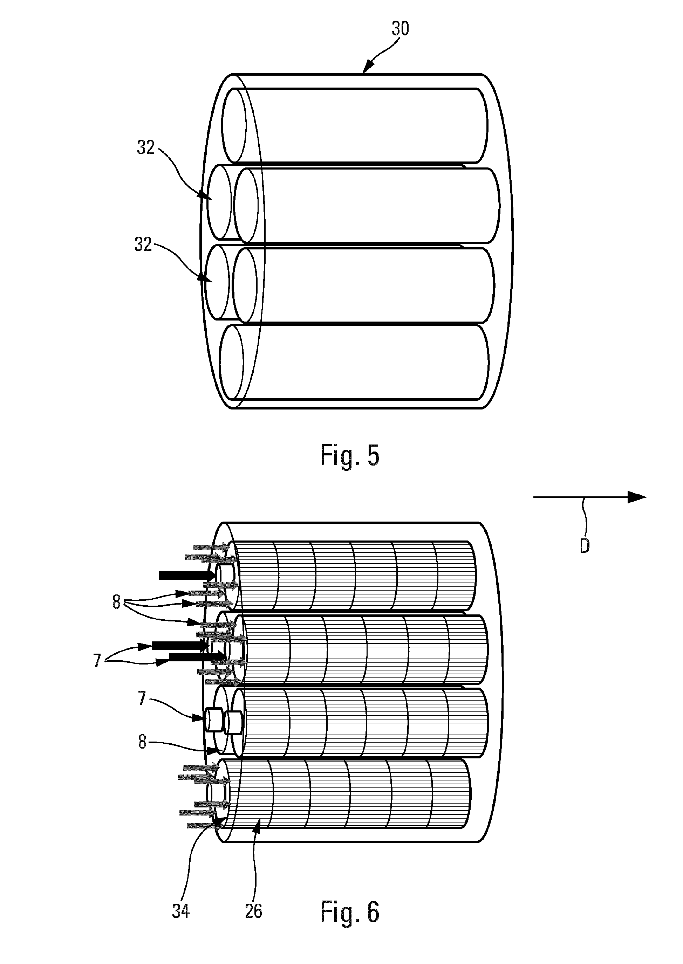

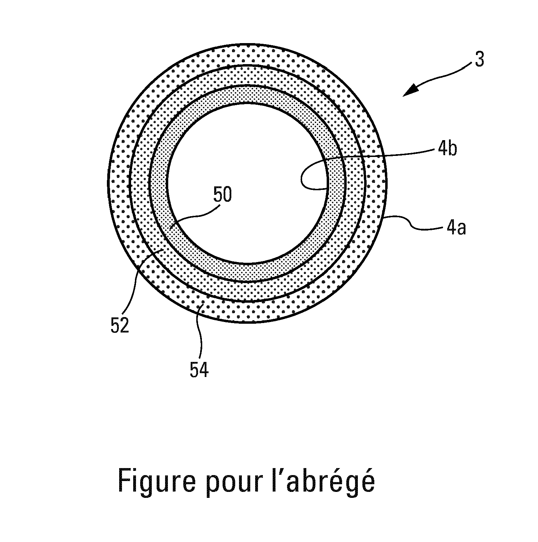

Comme illustré à la figure 5, ledit module pourra comprendre un corps 30 présentant une pluralité de logements 32 accueillant lesdits modules.

Ledit corps est, par exemple, en matériau réfractaire, isolant et/ou alvéolaire.

Comme illustré à la figure 6, lesdits modules, repérés 34 à cette figure pourront être insérés dans lesdits logements 32 et maintenus dans ceux-ci, notamment centrés, à l'aide des turbulateurs 26. La paroi externe du canal 8 de circulation de gaz pourra alors être définie directement par ledit corps 30. Ainsi, lesdits modules 34 sont maintenus dans lesdits logements 32 par les surfaces d'échange secondaires 9, notamment grâce à leur élasticité radiale.

Lesdits logements 32 sont disposés, notamment, de façon à ce que les canaux de circulation du gaz des différents modules soient parallèles les uns aux autres.

Ledit corps 30 présente, notamment, une configuration sensiblement cylindriques et les logements 32 sont parallèles entre eux et parallèle à l'axe du corps 30. Ils sont, par exemple, régulièrement espacés à sa périphérie.

D'un point de vue électrique, les modules pourront être connectés entre eux en série et/ou en parallèle, par des connexions, non représentées, situées à leurs extrémités longitudinales.

En variante, le dispositif pourra comprendre un canal de circulation de gaz by-passant lesdits modules. Il est prévu, notamment au centre dans corps.

Ledit corps pourra encore être revêtu d'une enveloppe externe 38 anti-choc.

Cela étant, les modules conformes à l'invention pourront être utilisés de façon individuelle plutôt que sous la forme de crayons, destinés à venir s'insérer dans les logements 32 d'accueil du corps 30 d'un dispositif thermo électrique tel que celui décrit plus haut.

L'invention concerne aussi un procédé de fabrication d'éléments thermo électrique 3 tel que décrit plus haut dans lequel :
- on prévoit différents mélanges dudit matériau thermo électrique et dudit matériau de dopage, présentant un taux de dopage donné,
- on dispose les mélanges de matériaux en couches situées les unes contre les autres,
- on effectue un traitement thermique desdites couches de mélange de matériau.

La disposition des matériaux en couche, ici en trois couches, s'effectue sans mélange entre les couches pour assurer le taux de dopage voulu dans chacune des couches.

Le traitement thermique a lieu, par exemple, par compactage puis frittage.

Selon un aspect de l'invention :
- on dispose au moins un séparateur, notamment un feuillard, cylindrique dans une cavité de moulage cylindrique de façon coaxiale à ladite cavité de moulage,
- on verse lesdits mélanges de matériau thermo électrique et de matériau de dopage présentant un taux de dopage donné de part et d'autre du ou des séparateurs afin de créer les différentes couches,
- on retire ensuite le ou les séparateurs avant d'effectuer le traitement thermique.

Les couches présentant des taux de dopages différents sont ainsi disposées concentriquement, ce qui permet de fabriquer les éléments thermo électriques 3 de forme annulaire décrits précédemment. On peut disposer de nombreux séparateurs afin de multiplier le nombre de couches présentant un taux de dopage différent.

Selon un exemple de réalisation de l'invention :
- on dispose les différents mélanges de matériau de base et de matériau de dopage en formant des parois destinées à définir lesdites faces de l'élément thermo électrique,
- on effectue le traitement thermique entre lesdites parois destinées à définir lesdites faces de l'élément thermo électrique.

Dans le cas d'éléments thermo électriques annulaires, le traitement thermique est appliqué entre les parois interne et externe du matériau thermo électrique annulaire. Un tel traitement présente notamment l'avantage de pouvoir traiter en une seule opération un empilement d'éléments thermo électriques de grande longueur, la distance faible entre les deux électrodes situées à l'intérieur et à l'extérieur de l'empilement annulaire ne dépendant pas de la longueur de l'empilement.

L'invention concerne aussi d'ailleurs un procédé de fabrication d'éléments thermo électriques en forme d'anneau permettant la génération d'un courant électrique à partir d'un gradient de température appliqué entre deux de ses faces, dites première et deuxième faces, procédé dans lequel :
- on dispose un matériau thermo électrique selon une forme annulaire en formant des parois destinées à définir les première et deuxième faces de l'élément thermo électrique, une première desdites parois étant une paroi interne de la forme annulaire et une seconde desdites parois étant une paroi externe de la forme annulaire.
- on effectue un traitement thermique entre lesdites première et seconde parois.

Le traitement thermique comprend, par exemple, une étape dans laquelle on fait circuler un courant électrique à travers le matériau thermo électrique entre lesdites première et seconde parois.

On pourra employer pour cela un dispositif à décharges électriques (non représenté) comprenant une première électrode, par exemple négative, et une deuxième électrode, par exemple positive. Lesdites électrodes sont disposées, notamment, de façon coaxiale et le matériau thermo électrique est disposé en couronne entre les deux électrodes.

Ainsi, après obtention des éléments thermo électriques 3, l'électrode est située à l'intérieur des anneaux formés par lesdits éléments thermo électriques 3. Plus précisément, elle est en contact aves leur seconde face 4b. La deuxième électrode est située à l'extérieur desdits anneaux formés par les éléments thermo électriques 3. Plus précisément, elle est en contact avec leur première face 4a. On applique de la sorte un courant électrique entre la périphérie intérieure et la périphérie extérieure des anneaux, c'est-à-dire entre la première et la seconde parois du matériau thermo électrique, en faisant circuler le courant dans le matériau thermo électrique entre l'électrode négative et l'électrode positive.

On pourra mettre en forme ledit matériau thermo électrique en couches superposées longitudinalement puis soumettre lesdites couches de matériau thermo électrique superposées longitudinalement audit traitement thermique de manière à obtenir lesdits éléments thermo électriques 3, chaque couche desdites couches superposées longitudinalement étant destinée à l'obtention de l'un desdits éléments thermo électriques 3.

Pour séparer lesdites couches de matériau thermo électrique superposées longitudinalement, on utilise, par exemple, une feuille de matériau. Il s'agit, notamment, d'une feuille de matériau isolante électriquement et/ou thermiquement et neutre aux opérations de frittage.

On forme ainsi, par exemple, des éléments thermo électriques 3 en forme d'anneau et munis des faces planes opposées 6a, 6b. Les feuilles de matériau sont situées entre lesdites faces planes opposées 6a, 6b de deux éléments thermo électrique voisins. Lesdites feuilles de matière se présentent sous la forme de disques avec un orifice central et leur taille correspond à l'espace entre les deux électrodes.

Après frittage, on obtient de la sorte un empilement d'éléments thermo électriques 3 et de feuilles de matériau intercalées que l'on dépile par la suite.

## Revendications

1. Elément thermo électrique (3) permettant la génération d'un courant électrique à partir d'un gradient de température appliqué entre deux de ses faces (4a, 4b), ledit élément (3) comprenant un matériau de base, apportant audit élément ses caractéristiques thermo électrique, et un matériau de dopage, apte à modifier les caractéristiques apportées audit élément par le matériau de base, **caractérisé par le fait que** ledit élément présente un taux de dopage croissant entre lesdites deux faces (4a, 4b), le taux de dopage étant défini comme la proportion de matériau de dopage par unité de volume.

2. Elément selon la revendication 1 dans lequel ledit matériau de dopage est constitué de terres rares.

3. Elément selon l'une quelconque des revendications 1 ou 2 comprenant une pluralité de couches (50, 52, 54) superposées entre lesdites deux faces (4a, 4b), le taux de dopage étant constant dans chacune desdites couches (50, 52, 54) et variant d'une couche à l'autre.

4. Elément selon la revendication 3 dans lequel lesdites deux faces (4a, 4b) sont prévues de surface différente et ledit élément (3) présente un taux de dopage croissant de celle desdites deux faces (4a) présentant la surface la plus grande à celle desdites deux faces (4b) présentant la surface la plus faible.

5. Elément selon la revendication 4 prévu de forme annulaire et dans lequel les couches (50, 52, 54) sont disposées concentriquement, la couche interne (50) présentant le taux dopage le plus élevé.

6. Procédé de fabrication d'éléments thermo électrique selon l'une quelconque des revendications 3 à 5 dans lequel :
- on prévoit différents mélanges dudit matériau thermo électrique et dudit matériau de dopage, présentant un taux de dopage donné,
- on dispose les mélanges de matériaux en couches (50, 52, 54) situées les unes contre les autres,
- on effectue un traitement thermique desdites couches (50, 52, 54) de mélange de matériau.

7. Procédé de fabrication selon la revendication 6, dans lequel :
- on dispose au moins un séparateur, notamment un feuillard, cylindrique dans une cavité de moulage cylindrique de façon coaxiale à ladite cavité de moulage,
- on verse lesdits mélanges de matériau thermo électrique et de matériau de dopage présentant un taux de dopage donné de part et d'autre du ou des séparateurs afin de créer les différentes couches,
- on retire ensuite le ou les séparateurs avant d'effectuer le traitement thermique.

8. Procédé de fabrication selon la revendication 6 ou 7 dans lequel
- on dispose un matériau thermo électrique en formant des parois destinées à définir lesdites faces (4a, 4b) de l'élément thermo électrique (3),
- on effectue le traitement thermique entre lesdites parois destinées à définir lesdites faces (4a, 4b) de l'élément thermo électrique (3).

9. Procédé de fabrication d'éléments thermo électriques (3) en forme d'anneau permettant la génération d'un courant électrique à partir d'un gradient de température appliqué entre deux de ses faces (4a, 4b), dites première et seconde faces (4a, 4b), procédé dans lequel :
- on dispose un matériau thermo électrique selon une forme annulaire en formant des parois destinées à définir les première et seconde faces de l'élément thermo électrique, une première desdites parois étant une paroi interne de la forme annulaire et une seconde desdites parois étant une paroi externe de la forme annulaire.
- on effectue un traitement thermique entre lesdites première et seconde parois.

10. Module thermo électrique comprenant au moins un élément thermo électrique (3) selon l'une quelconque des revendications 1 à 5

11. Module selon la revendication 10, prise dans son rattachement aux revendications 4 ou 5, ledit module étant configuré pour établir, d'une part, un échange thermique entre celle (4a) des deux faces la plus grande dudit élément thermo électrique (3) et un premier fluide et, d'autre part, pour établir un échange thermique entre celle (4b) des deux faces la plus petite dudit élément thermo électrique et un second fluide, ledit second fluide présentant un coefficient d'échange thermique supérieure audit premier fluide.

12. Module selon la revendication 11 comprenant un canal (7) de circulation du second fluide au contact de ladite seconde surface (4b) desdits éléments thermo électriques (3, 3p, 3n) et/ou un canal (8) de circulation du premier fluide au contact de ladite première surface (4a) desdits éléments thermo électriques (3, 3p, 3n).

13. Dispositif thermo électrique, notamment destiné à générer un courant électrique dans un véhicule automobile, comprenant au moins un module selon l'une quelconque des revendications 10 à 12.
